# EUROPEAN PATENT APPLICATION

(11) **EP 4 207 575 A1**
(43) Date of publication of application: **05.07.2023**
(21) Application number: 21861572.2
(22) Date of filing: 24.08.2021
(51) Int. Cl.: H02N 2/18

(54) **VIBRATION POWER GENERATION DEVICE, SENSOR MODULE, AND MANUFACTURING METHOD**

(30) Priority: 25.08.2020 JP 2020142035
(71) Applicant: Kyocera Corporation, Kyoto-shi Kyoto 612-8501 (JP)
(72) Inventor: KITAYAMA, Satoshi, Kyoto-shi, Kyoto 612-8501 (JP); OOKUBO, Tomoaki, Kyoto-shi, Kyoto 612-8501 (JP)
(74) Representative: TBK
(86) International application number: PCT/JP2021/031033
(87) International publication number: WO 2022/045148

(57) **Abstract**

A vibration power generation device includes a weight, beams, piezoelectric members, and a fixation member. The beams extend from the weight in directions parallel to a single plane. The piezoelectric members are disposed at respective beams. The fixation member includes at least a frame-shaped portion. The beams are fixed to the frame-shaped portion in such a manner that the weight and the piezoelectric members are positioned inside the frame-shaped portion.

## Description

### CROSS-REFERENCE TO RELATED APPLICATIONS

This application claims the benefit of Japanese Patent Application No. 2020-142035 filed August 25, 2020, which is hereby incorporated by reference herein in its entirety.

### TECHNICAL FIELD

The present disclosure relates to a vibration power generation device, a sensor module, and a method of manufacturing the vibration power generation device.

### BACKGROUND OF INVENTION

As the Internet of Things (IoT) technology becomes popular, sensor modules, which detect various states of things and transmit the detection results, are expected to expand the application area. Studies are conducted on obtaining energy from the ambient environment and generating the electric power for actuating the sensor module. For example, in the case of a sensor module attached to a vehicle tire, an energy generation device using piezoelectric elements is proposed (Patent Literature 1). In the energy generation device, the sensor module uses piezoelectric elements to generate electric power. The tire is subjected to centrifugal force and deformation while running on the road, and pressing forces acting on the tire deform the piezoelectric elements repeatedly, thereby generating the electric power.

### CITATION LIST

### PATENT LITERATURE

Patent Literature 1: Japanese Unexamined Patent Application Publication (Translation of PCT Application) No. 2010-515616

### SUMMARY

According to a first aspect of the present disclosure, a vibration power generation device includes a weight, beams, piezoelectric members, and a fixation member. The beams extend from the weight in directions parallel to a single plane. The piezoelectric members are disposed at respective beams. The fixation member includes at least a frame-shaped portion. The beams are fixed to the frame-shaped portion in such a manner that the weight and the piezoelectric members are positioned inside the frame-shaped portion.

According to a second aspect of the present disclosure, a sensor module includes the vibration power generation device, a sensor, a communication unit, and a controller. The vibration power generation device includes the weight, the beams extending from the weight in directions parallel to the single plane, the piezoelectric members disposed at respective beams, and the fixation member including at least the frame-shaped portion. The beams are fixed to the frame-shaped portion in such a manner that the weight and the piezoelectric members are positioned inside the frame-shaped portion. The sensor is actuated by electric power supplied from the vibration power generation device. The communication unit is actuated by the electric power supplied from the vibration power generation device and is configured to communicate with an external device. The controller is actuated by the electric power supplied from the vibration power generation device and is configured to control the sensor and the communication unit.

According to a third aspect of the present disclosure, a method of manufacturing the vibration power generation device includes a step of fixing a beam and a step of attaching a weight. In the step of fixing the beam, the beam is fixed to a fixation member shaped entirely like a frame in such a manner that the beam extends inward from the frame-shaped fixation member and that the beam forms a straight line with, or intersects, another beam inside the frame-shaped fixation member. In the step of attaching the weight, the weight is attached to the beam in the axial direction of the frame-shaped fixation member.

### BRIEF DESCRIPTION OF THE DRAWINGS

FIG. 1 is a functional block diagram schematically illustrating a sensor module that includes a vibration power generation device according to an embodiment.
FIG. 2 is a cross-sectional view illustrating the vibration power generation device of the embodiment, which is cut in a vibration direction of the vibration power generation device.
FIG. 3 is a top view illustrating the vibration power generation device of FIG. 2 when the vibration power generation device is viewed in the vibration direction and a housing is removed.
FIG. 4 is a top view illustrating a modification example of the vibration power generation device of FIG. 2 when the vibration power generation device is viewed in the vibration direction and the housing is removed.
FIG. 5 is a top view illustrating another modification example of the vibration power generation device of FIG. 2 when the vibration power generation device is viewed in the vibration direction and the housing is removed.
FIG. 6 is a top view illustrating another modification example of the vibration power generation device of FIG. 2 when the vibration power generation device is viewed in the vibration direction and the housing is removed.
FIG. 7 is a cross-sectional view illustrating an intermediate product of the vibration power generation device that is cut in the axial direction, the view being provided for the explanation of a fixation step of fixing beams to a fixation member according to a method of manufacturing the vibration power generation device of FIG. 2.
FIG. 8 is a cross-sectional view illustrating an intermediate product of the vibration power generation device that is cut in the axial direction, the view being provided for the explanation of a step of attaching a weight to the beam according to the method of manufacturing the vibration power generation device of FIG. 2.
FIG. 9 is a top view illustrating another modification example of the vibration power generation device of FIG. 2 when the vibration power generation device is viewed in the vibration direction and the housing is removed.

### DESCRIPTION OF EMBODIMENT

An embodiment of the vibration power generation device according to the present disclosure is described with reference to the drawings.

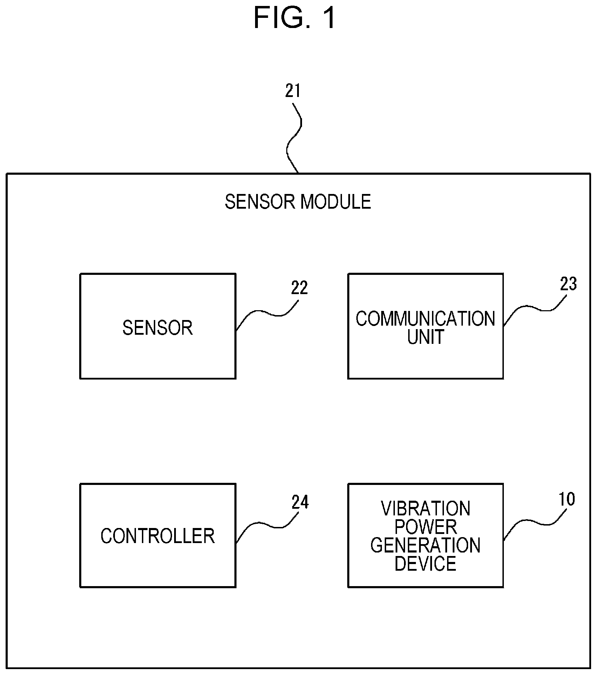

As illustrated in FIG. 1, a vibration power generation device 10 according to an embodiment of the present disclosure is disposed in a sensor module 21. The sensor module 21 includes a sensor 22, a communication unit 23, a controller 24, and the vibration power generation device 10. The sensor module 21 is configured to detect various states of things and transmits the detection results to an external device without receiving electric power from outside. The sensor module 21 is applied to, for example, a bridge, a railroad car, a vehicle, a power plant, an outdoor machine, or a factory machine.

The sensor 22 is configured to detect an arbitrary state of an arbitrary object. Examples of the sensor 22 are a vibration sensor, a temperature sensor, and a pressure sensor. The sensor 22 is actuated by the electric power supplied from the vibration power generation device 10.

The communication unit 23 includes a communication module for communication with an external device through a network. For example, the sensor 22 detects an arbitrary state of a thing, and the communication unit 23 transmits signals containing detection results to the external device. The communication unit 23 may receive instructions from the external device and transmit the instructions to the controller 24. The communication unit 23 is actuated by the electric power supplied from the vibration power generation device 10.

The controller 24 includes one or more processors and a memory. The processor may be a general purpose processor that performs a specific function in accordance with a specific program provided or may be a special purpose processor dedicated to a specific function. The special purpose processor may include an application specific integrated circuit (ASIC). The processor may include a programmable logic device (PLD). The PLD may further include a field-programmable gate array (FPGA). The controller 24 may be either a system in a package (SiP) or a system on a chip (SoC) in which one or more processors collaborate. The controller 24 controls the sensor 22 and the communication unit 23. The controller 24 is actuated by the electric power supplied from the vibration power generation device 10.

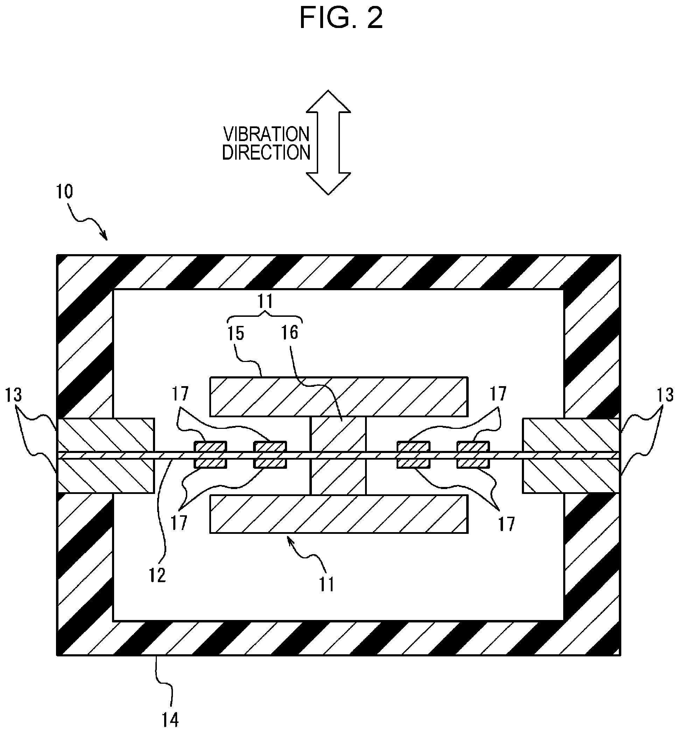

As illustrated in FIG. 2, the vibration power generation device 10 includes a weight 11, a plurality of beams 12, piezoelectric members 17, and a fixation member 13. The vibration power generation device 10 may also include a housing 14.

The weight 11 provides inertia to the beams 12 that are supported by the fixation member 13 (to be described later), thereby intensifying the vibration of the beams 12. The weight 11 may be disposed at a surface of the plurality of beams 12, the surface facing in the vibration direction in which the plurality of beams 12 vibrates. The weight 11 may be disposed at opposite surfaces of the plurality of beams 12, the surfaces facing in the vibration direction.

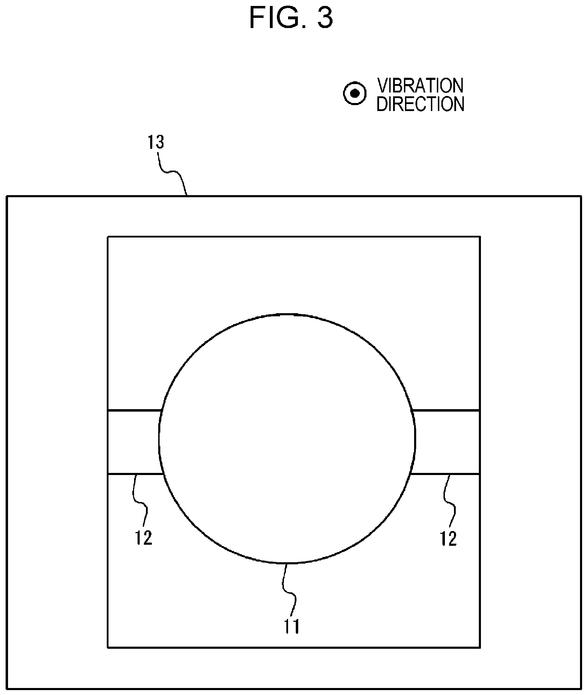

The weight 11 may include a main body 15 and a neck 16. As illustrated in FIG. 3, the main body 15 is shaped like a circular plate. As illustrated in FIG. 2, the neck 16 may be shaped like a column, such as a solid cylinder, that is thinner than the main body 15. The central axis of the neck 16 may pass through the center of the circular main body 15 in a direction normal to the surface of the main body 15. The neck 16 may be fixed to the plurality of beams 12 such that the central axis of the neck 16 extends parallel to the vibration direction. In the case where the weights 11 are disposed respectively at the opposite surfaces of the plurality of beams 12 that face in the vibration direction, two necks 16 of respective weights 11 may be disposed such that the central axes of the two necks 16 are aligned with a straight line.

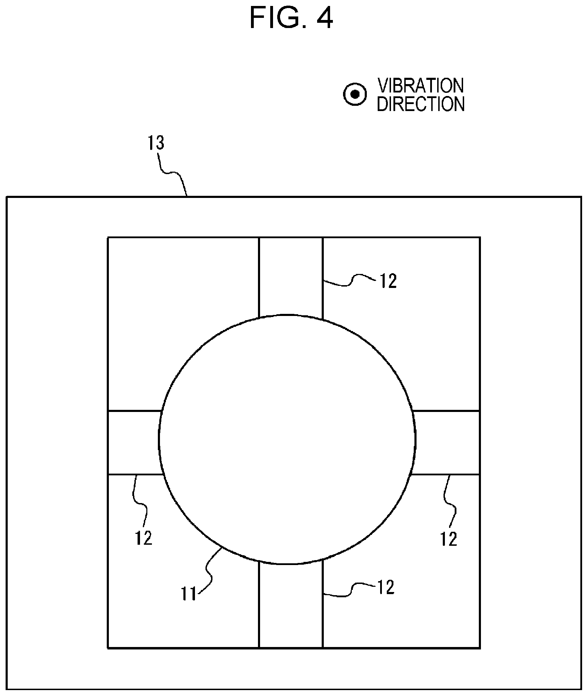

As illustrated in FIG. 3, the beams 12 extend from the weight 11 in different directions. In the present embodiment, two beams 12 extend from the weight 11. As illustrated in FIG. 4, four beams 12 may extend from the weight 11 in respective four directions. Each two of the four beams 12 may extend from the weight 11 in opposite directions so as to form a straight line. Each two of the beams 12 extending from the weight 11 in the opposite directions may be made of a single member. As illustrated in FIG. 2, the directions in which respective beams 12 extend are parallel to a single imaginary plane (in other words, a single plane). More specifically, the beams 12 may extend in respective directions along the single imaginary plane.

The thickness of each beam 12 in the vibration direction, in other words, in the direction normal to the imaginary plane, may be smaller than the width of the beam 12. More specifically, the beam 12 is a thin plate, and the principal surfaces of the beam 12 extend orthogonal to the vibration direction.

The beam 12 may be made of a metal, such as a stainless steel (SUS).

The piezoelectric member 17 is disposed at each beam 12. The piezoelectric member 17 may be disposed at a position at which stress occurs to the piezoelectric member 17 due to the vibration of the beam 12. The piezoelectric members 17 may be disposed on the plane on which the beams 12 are disposed. Each piezoelectric member 17 may be disposed on a surface of each beam 12 that faces in the vibration direction. Multiple piezoelectric members 17 may be arranged side by side on a single beam 12 in the extending direction of the beam 12. Multiple piezoelectric members 17 may be disposed respectively on opposite surfaces of each beam 12 that face in the vibration direction.

Each piezoelectric member 17 includes an insulating film, a first electrode, a piezoelectric film, and a second electrode, which are laminated in this order from the beam 12. The deformation of the beam 12 due to vibration deforms the piezoelectric member 17. Accordingly, when the beam 12 vibrates, the piezoelectric film inside the piezoelectric member 17 is subjected to stress, and the stress is converted into electric power due to the piezoelectric effect of the piezoelectric film. The electric power generated in the piezoelectric film is output to the first and the second electrodes and further to a device outside the vibration power generation device 10.

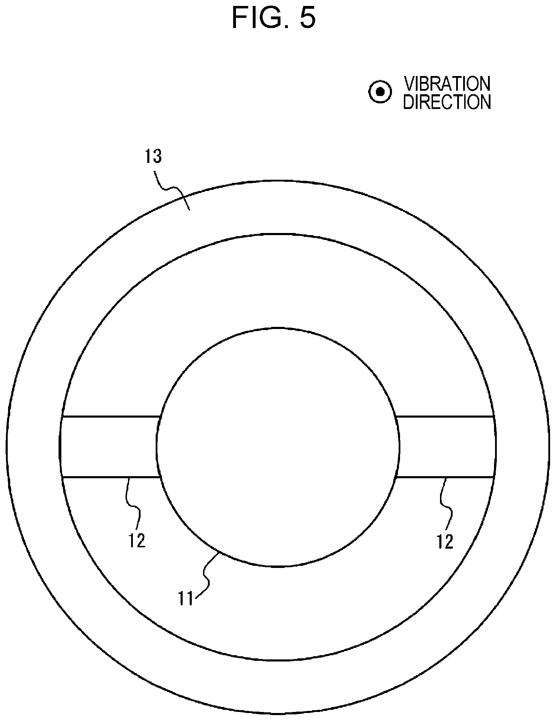

The fixation member 13 includes at least a frame-shaped portion. The central axis of the frame-shaped portion of the fixation member 13 may extend in a direction perpendicular to the vibration direction, in other words, perpendicular to the direction normal to the above-described imaginary plane. The fixation member 13 may be shaped entirely like a frame or may be shaped like a container in which one end of the frame-shaped portion in the axial direction is covered. The frame-shaped portion of the fixation member 13 may be shaped rectangularly. Alternatively, as illustrated in FIG. 5, the frame-shaped portion of the fixation member 13 may be shaped circularly. The weight 11 is entirely exposed from the fixation member 13 that is shaped entirely like the frame when the fixation member 13 is viewed in the vibration direction, in other words, viewed in the direction normal to the above-described imaginary plane.

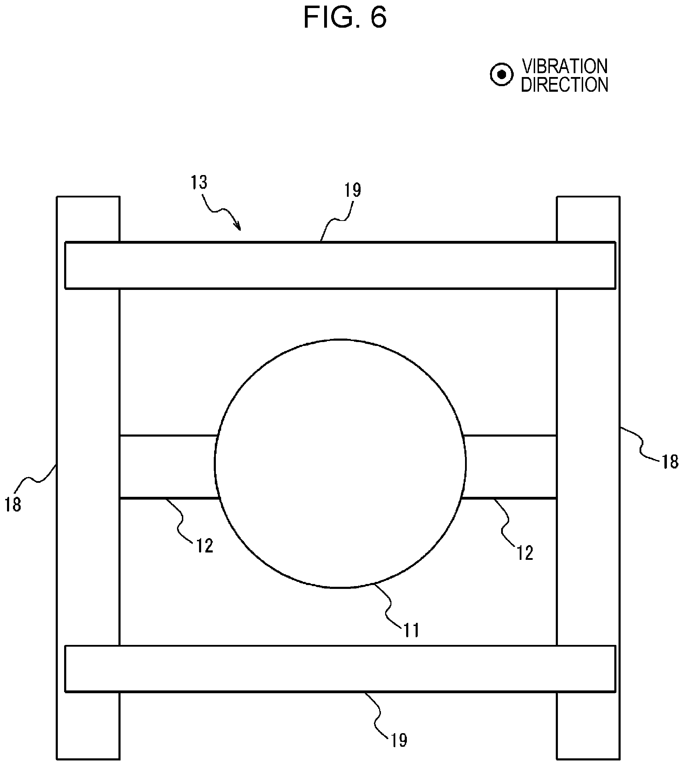

The frame-shaped portion of the fixation member 13 may include multiple sub-portions that form the frame. For example, as illustrated in FIG. 6, the frame-shaped portion of the fixation member 13 may be made of two fixation members 18 to which the beams 12 are fixed and two spacing adjustment members 19 that hold the two fixation members 18 apart from each other.

The beams 12 are fixed to the frame-shaped portion of the fixation member 13 in such a manner that the weight 11 and the piezoelectric members 17 are positioned inside the frame-shaped portion. The beams 12 are fixed to the fixation member 13 using an arbitrary method. As illustrated in FIG. 2, the fixation member 13 may be made of a frame-shaped portion that can be separated into two parts, and the beams 12 are nipped by the two parts in the vibration direction.

The fixation member 13 is preferably made of a high-rigidity material. Examples of the material may be a metal such as Fe, an alloy containing Fe, Ni, and Cr as main components, a stainless steel (SUS), and a nonmetallic material such as a resin.

The housing 14 may accommodate the weight 11 and the beams 12. The housing 14 may support the fixation member 13.

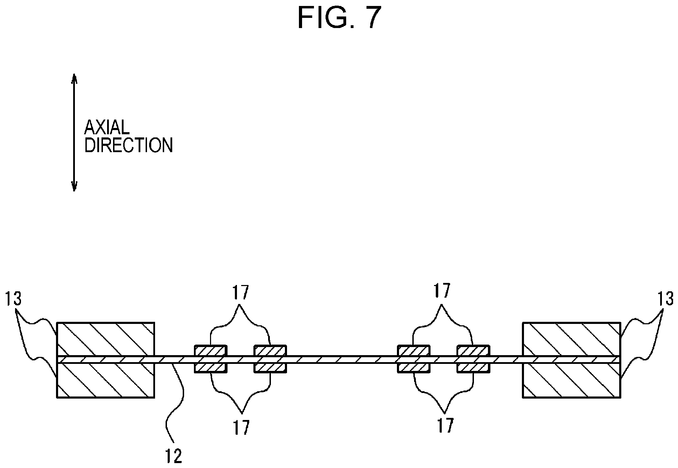

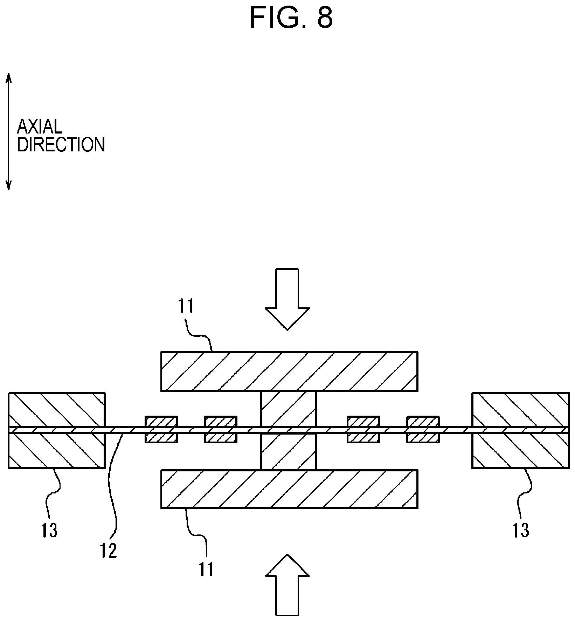

Next, a method of manufacturing the vibration power generation device 10 is described. As illustrated in FIG. 7, each beam 12 is fixed to the frame-shaped fixation member 13 in such a manner that each beam 12 extends inward from the frame-shaped fixation member 13 so as to form a straight line with another beam 12 or so as to intersect another beam 12 inside the frame-shaped fixation member 13. Note that the piezoelectric member 17 may be disposed at each beam 12 before the beam 12 is fixed to the fixation member 13. Subsequently, as illustrated in FIG. 8, the weight 11 is attached to the beams 12 in the axial direction of the frame-shaped fixation member 13.

According to the present embodiment, the above-described vibration power generation device 10 includes the weight 11, the beams 12, the piezoelectric members 17, and the fixation member 13. The beams 12 extend from the weight 11 in directions parallel to the single imaginary plane, and the piezoelectric members 17 are disposed at respective beams 12. The fixation member 13 includes at least the frame-shaped portion. The beams 12 are fixed to the frame-shaped portion in such a manner that the weight 11 and the piezoelectric members 17 are positioned inside the frame-shaped portion. In the case where the beams extending from the weight are fixed individually to the fixation member, the beams tend to warp vertically downward due to the presence of the weight. If the beams are warped before vibration, the output of the electric power decreases during vibration. In the vibration power generation device 10 according to the present embodiment, however, the beams 12 are fixed to the frame-shaped portion of the fixation member 13, which can reduce relative displacement of the fixation positions along the imaginary plane, the imaginary plane being parallel to the extending directions of unwarped beams 12. Accordingly, in the vibration power generation device 10, a reduction in the relative displacement of the fixation positions along the imaginary plane leads to a reduction in the amount of warp of the beams 12. As a result, the vibration power generation device 10 can reduce the amount of warp of the beams 12, which can increase the electricity output.

In the vibration power generation device 10 of the present embodiment, the thickness of each beam 12 in the direction normal to the imaginary plane is smaller than the width of each beam 12. Accordingly, the vibration power generation device 10 generates vibrations easily in the direction normal to the imaginary plane. As a result, the vibration power generation device 10 increases the frequency with which the electric power is generated by the piezoelectric members 17 disposed so as to face in the direction normal to the imaginary plane.

In addition, in the vibration power generation device 10 of the present embodiment, the fixation member 13 is shaped entirely like the frame, and the weight 11 is entirely exposed from the fixation member 13 as viewed in the direction normal to the imaginary plane. According to this configuration, the vibration power generation device 10 can be manufactured such that the beams 12 are first fixed to the fixation member 13 before the weight 11 is attached as illustrated in FIG. 7, and subsequently the weight 11 is attached to the beams 12 in the axial direction of the frame-shaped fixation member 13 as illustrated in FIG. 8. Accordingly, in the vibration power generation device 10, the beams 12 can be fixed to the fixation member 13 while the amount of warp of the beams 12 caused by the weight 11 is reduced, which results in a further reduction in the amount of warp of the beams 12 after the weight 11 is attached and accordingly results in an increase in the electricity output.

The present invention has been described with reference to the drawings and through examples. Note that those skilled in the art can modify and alter the embodiment easily on the basis of the present disclosure. Accordingly, such modifications and alterations are deemed within the scope of the invention.

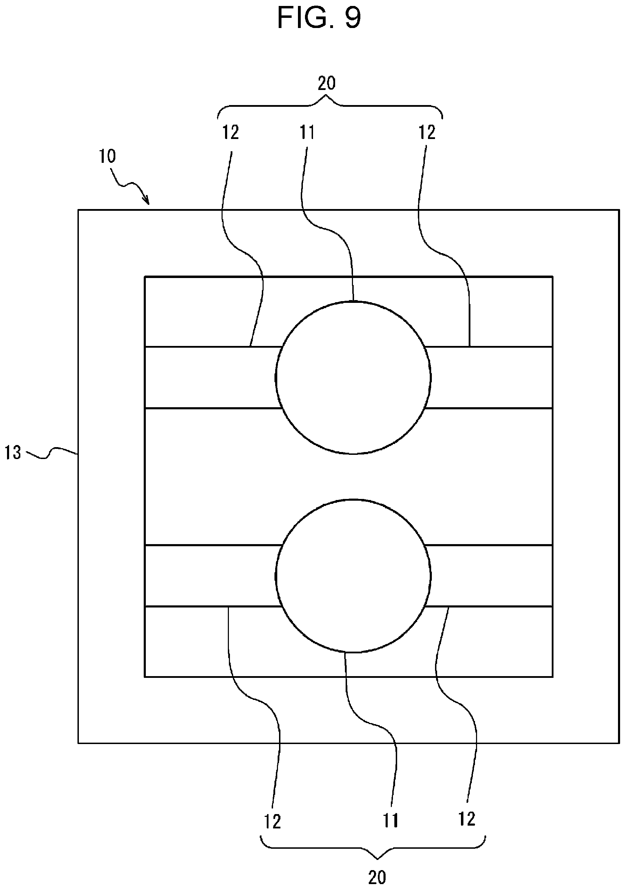

For example, in the present embodiment, the vibration power generation device 10 includes two beams 12 that extend from a single weight 11 in opposite directions so as to form a straight line. The configuration of the weight 11 and the beams 12 is not limited to this. For example, as illustrated in FIG. 9, the vibration power generation device 10 may include multiple sets 20 of the weight 11 and the two beams 12 that extend from the weight 11 in opposite directions so as to form a straight line. The beams 12 included in each set 20 may be fixed to the frame-shaped portion of the fixation member 13.

### REFERENCE SIGNS

- 10: vibration power generation device
- 11: weight
- 12: beam
- 13: fixation member
- 14: housing
- 15: main body
- 16: neck
- 17: piezoelectric member
- 18: fixation member
- 19: spacing adjustment member
- 20: set
- 21: sensor module
- 22: sensor
- 23: communication unit
- 24: controller

## Claims

1. A vibration power generation device comprising:
a weight;
beams extending from the weight in directions parallel to a single plane;
piezoelectric members disposed at respective beams; and
a fixation member including at least a frame-shaped portion, wherein
the beams are fixed to the frame-shaped portion in such a manner that the weight and the piezoelectric members are positioned inside the frame-shaped portion.

2. The vibration power generation device according to claim 1, wherein
a thickness of each beam in a direction normal to the plane is smaller than a width of each beam.

3. The vibration power generation device according to claim 1 or 2, wherein
the fixation member is shaped entirely like a frame.

4. The vibration power generation device according to claim 3, wherein
the weight is entirely exposed from the fixation member as viewed in the direction normal to the plane.

5. The vibration power generation device according to any one of claims 1 to 4, further comprising:
multiple sets of the weight and two of the beams, the two of the beams extending straight from the weight in opposite directions.

6. The vibration power generation device according to any one of claims 1 to 5, wherein
a central axis of the frame-shaped portion extends in a direction perpendicular to the directions of the beams extending from the weight.

7. A sensor module, comprising:
the vibration power generation device according to any one of claims 1 to 6;
a sensor actuated by electric power supplied from the vibration power generation device;
a communication device actuated by the electric power supplied from the vibration power generation device and configured to communicate with an external device; and
a controller actuated by the electric power supplied from the vibration power generation device and configured to control the sensor and the communication device.

8. The sensor module according to claim 7, wherein
the sensor module is applied to a bridge, a railroad car, a vehicle, a power plant, an outdoor machine, or a factory machine.

9. A method of manufacturing the vibration power generation device, the method comprising:
a step of fixing a beam to a fixation member shaped entirely like a frame in such a manner
that the beam extends inward from the frame-shaped fixation member, and
that the beam forms a straight line with, or intersects, another beam inside the frame-shaped fixation member; and
a step of attaching a weight to the beam in an axial direction of the frame-shaped fixation member.
